# EUROPÄISCHE PATENTSCHRIFT

(11) **EP 0 460 285 B1**
(45) Veröffentlichungstag und Bekanntmachung des Hinweises auf die Patenterteilung: **28.08.1996**
(21) Anmeldenummer: 90123356.9
(22) Anmeldetag: 05.12.1990
(51) Int. Cl.: H01L 21/331, H01L 29/06

(54) **Verfahren zur Herstellung von Bipolartransistoren mit extrem reduzierter Basis-Kollektor-Kapazität**
Process for manufacturing bipolar transistors with an extremely reduced base-collector capacitance
Procédé de fabrication d'un transistor bipolaire ayant une capacité base-collecteur extrêmement réduite

(30) Priorität: 07.06.1990 DE 4018298
(43) Veröffentlichungstag der Anmeldung: 11.12.1991
(73) Patentinhaber: SIEMENS AKTIENGESELLSCHAFT, 80333 München (DE)
(72) Erfinder: Tews, Helmut, Dr. Dipl.-Phys., W-8025 Unterhaching (DE); Zwicknagl, Hans-Peter, Dr.-Dipl.-Phys., W-7000 Stuttgart 80 (DE)

(56) Entgegenhaltungen:
- EP-A- 0 168 324
- WO-A-88/08206
- DE-A- 3 512 841
- US-A- 4 380 774
- ELECTRONICS LETTERS, Band 26, Nr. 3, 1. Februar 1990, Seiten 203-205, Stevenage, Herts., GB; Y. OTA et al.: "AlGaAs/GaAs Heterojunction Bipolar Transistors Fabricated with Various Collector-Carrier-Concentrations"
- GAAS IC SYMPOSIUM, TECHNICAL DIGEST, 22-25. Okt. 1989, San Diego, US, Seiten 135-138; R.N. NOTTENBURG et al.: "InP-Based Heterostructure Bipolar Transistors"
- IBM TECHNICAL DISCLOSURE BULLETIN, Band 22, Nr. 2, Juli 1979, Seiten 577-579, New York, US; J.R. CAVALIERE et al.: "Process for Making Self-Aligned Deep and Shallow Isolation Trenches for Transistors"

## Beschreibung

Die vorliegende Erfindung betrifft ein Verfahren zur Herstellung von Bipolartransistoren gemäß dem Oberbegriff des Anspruches 1.

Bei GaAs-GaAlAs-Heterobipolartransistoren werden die Transitfrequenz und die maximale Oszillationsfrequenz stark von parasitären Kapazitäten und Serienwiderständen beeinflußt. Beispiele für parasitäre Kapazitäten sind die Kapazität zwischen der Emitterschicht und der Basisschicht oder zwischen der Basisschicht und der Kollektorschicht außerhalb des inneren Transistorbereiches. Um hohe Werte für die maximale Oszillationsfrequenz zu erreichen, müssen der Bahnwiderstand der Basis und die Basis-Kollektor-Kapazität minimiert werden.

Grundsätzlich ist es möglich, parasitäre Kapazitäten durch Verkleinerung von Strukturen, insbesondere durch Verringerung des Abstandes zwischen Basis und Emitter bzw. zwischen der Basis und dem Kollektorkontakt, zu reduzieren. Eine weitere Möglichkeit, die extrinsische Basis-Kollektor-Kapazität zu reduzieren, bietet eine Isolationsimplantation (z. B. Sauerstoff) im extrinsischen Basis-Kollektor-Gebiet (P.M. Asbeck, D.L. Miller, R.J. Anderson and F.H. Eisen, IEEE Electron Device Letters EDL-5, 310 - 312 (1984)). Nachteilig dabei sind die notwendigen hohen Implantationsenergien. Diese hohen Implantationsenergien erfordern Masken aus Metall. Außerdem verursachen diese Implantationen auch Schäden in den oberen Basisschichten, die die Transistoreigenschaften nachteilig verändern.

Aufgabe der vorliegenden Erfindung ist es, ein einfach auszuführendes Herstellungsverfahren für Bipolartransistoren anzugeben, deren Kenndaten gegenüber nach herkömmlichen Verfahren hergestellten Bipolartransistoren nicht verschlechtert sind und die eine minimale Basis-Kollektor-Kapazität aufweisen.

Diese Aufgabe wird mit dem Verfahren mit den Merkmalen des Anspruches 1 gelöst. Weitere Ausgestaltungen ergeben sich aus den Unteransprüchen.

Es folgt eine Beschreibung des erfindungsgemäßen Verfahrens anhand der Fig. 1 bis 5.

Fig. 1 zeigt eine Aufsicht auf den fertigen Transistor mit der Anordnung der Kontakte für die Basis, den Emitter und den Kollektor.

Fig. 2 bis 4 zeigen den Transistor in drei verschiedenen Verfahrensschritten im Querschnitt.

Fig. 5 zeigt den Verfahrensschritt entsprechend Fig. 2 in einer alternativen Ausführungsform.

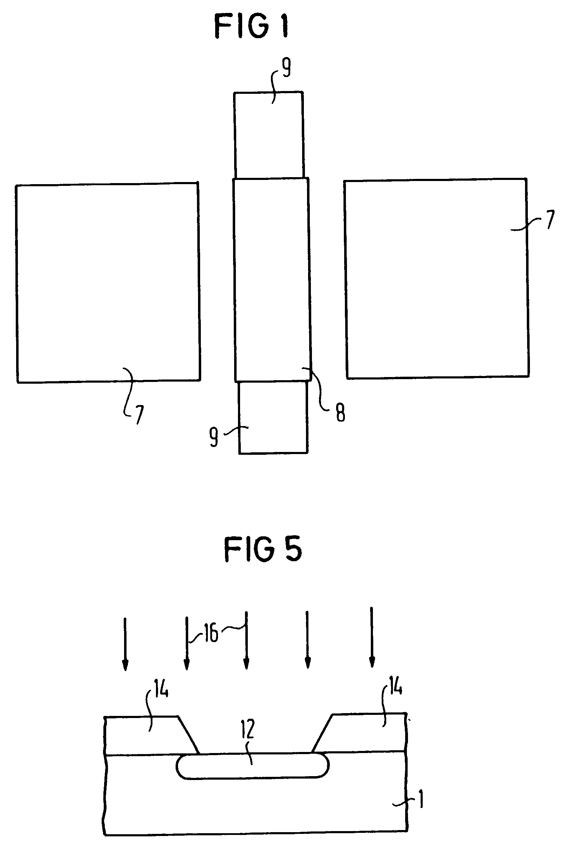

Das erfindungsgemäße Herstellungsverfahren umgeht die nachträgliche Isolationsimplantation, indem vor dem Aufwachsen der eigentlichen Transistorschichten ein lokal auf den inneren Transistor begrenzter Subkollektorbereich durch laterale Isolationsimplantierung ausgebildet wird. In der Fig. 1 sind in Aufsicht der Basiskontakt 7, der Emitterkontakt 8 und der Kollektorkontakt 9 dargestellt. Der von dem erfindungsgemäß hergestellten Subkollektor eingenommene Bereich umfaßt die von dem Emitterkontakt 8 und von dem Kollektorkontakt 9 eingenommenen Bereiche.

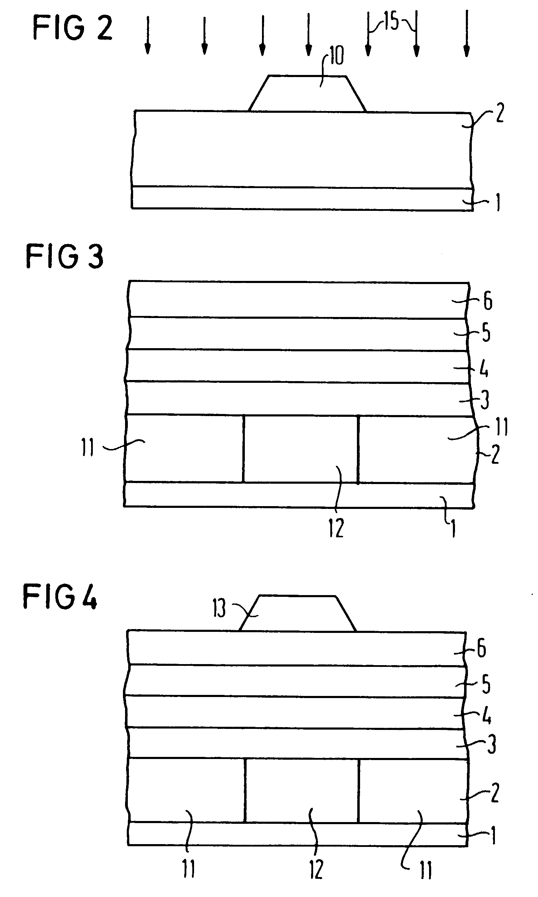

In einem ersten Ausführungsbeispiel des erfindungsgemäßen Verfahrens wird auf ein Substrat 1 eine Subkollektorschicht 2, die für gute Leitfähigkeit hoch dotiert ist, abgeschieden. Das Substrat 1 ist aus isolierendem Halbleitermaterial und wird vorteilhaft mit Justiermarken versehen. Der für den Subkollektor vorgesehene Bereich wird mit einer ersten Maske 10 (s. Fig. 2) abgedeckt. Dieser abgedeckte Bereich des Subkollektors hat nur die Größe des inneren Transistors (d. h. im wesentlichen des Emitterbereiches) plus einer seitlichen Herausführung für den späteren Kollektoranschluß mittels eines Kontaktes auf dem Subkollektor 12. Der übrige Anteil der Subkollektorschicht 2 wird durch eine Isolationsimplantation 15 (z. B. Sauerstoff) isoliert, oder es wird zumindest durch diese Isolationsimplantation 15 die elektrische Leitfähigkeit dieses Anteiles der Subkollektorschicht 2 stark vermindert.

Nach dem Entfernen der ersten Maske 10 und dem Reinigen der Oberfläche der Subkollektorschicht 2 werden die weiteren Schichten für den Bipolartransistor epitaktisch aufgewachsen. In Fig. 3 sind die aufgewachsenen Schichten, nämlich die Kollektorschicht 3, die Basisschicht 4, die Emitterschicht 5 und die Deckschicht 6 dargestellt. Die nachfolgenden Verfahrensschritte, die insbesondere die Strukturierung des Emitter-Basis-Komplexes betreffen, entsprechen den aus dem Stand der Technik bekannten Prozessen. Dabei ist allerdings ein weiterer Verfahrensschritt erforderlich, mittels dessen der zu strukturierende Emitterbereich auf den durch die erste Maske 10 festgelegten Subkollektorbereich justiert werden muß. Zu diesem Zweck wird eine zweite Maske 13, wie in Fig. 4 eingezeichnet, erforderlich. In den Figuren 3 und 4 sind der Subkollektor 12 und die den Subkollektor 12 lateral begrenzenden, durch die Isolationsimplantation 15 behandelten isolierenden Bereiche 11 eingezeichnet. Die Justierung des Emitters auf den Subkollektor 12 erfolgt durch einen Ätzschritt unter Benutzung der zweiten Maske 13, bei dem seitlich dieser zweiten Maske 13 das Material der Deckschicht 6 und der Emitterschicht 5 abgetragen wird, oder durch eine laterale Isolationsimplantierung, bei der der Emitterbereich durch diese zweite Maske 13 abgedeckt ist. Für die Kontaktierung der Basis wird dann in einem späteren Verfahrensschritt ein Teil der Deckschicht 6 und der Emitterschicht 5 weggeätzt.

Ein besonderer Vorteil des erfindungsgemäßen Verfahrens liegt darin, daß die Kollektorschicht 3 in den Bereichen oberhalb der isolierenden Bereiche 11 der Subkollektorschicht 2 an Ladungsträgern verarmt ist und daher keinen Beitrag zur Basis-Kollektor-Kapazität liefert. Ist die Subkollektorschicht 2 unter dem Basisanschluß vollständig isoliert, d. h. befinden sich die Basiskontakte 7 in der vertikalen Projektion über den isolierenden Bereichen 11 und isolieren diese Bereiche 11 vollständig, dann ist die extrinsische "parasitäre" Basis-Kollektor-Kapazität praktisch gleich null.

In Fig. 5 ist der Verfahrensschritt entsprechend Fig. 2 in einem alternativen Ausführungsbeispiel dargestellt. Bei diesem zweiten Ausführungsbeispiel wird die erste Maske 14 unmittelbar auf das Substrat 1 aus z. B. GaAs aufgebracht. Diese erste Maske 14 läßt den für den Subkollektor vorgesehenen Bereich frei, bedeckt also gerade den zu dem ersten Ausführungsbeispiel komplementären Anteil der Substratoberfläche. Durch die Öffnung dieser ersten Maske 14 wird dann eine Implantation 16 zur Dotierung vorgenommen, wodurch das zunächst semiisolierende Substrat 1 in dem für den Subkollektor 12 vorgesehenen Bereich leitfähig wird. Danach wird die erste Maske 14 entfernt, die Oberfläche des Substrates gereinigt und die Dotierung ausgeheilt. Anschließend erfolgen die gleichen Verfahrensschritte wie im ersten Ausführungsbeispiel, d. h. das Aufwachsen der Schichten entsprechend Fig. 3. Die übrigen Verfahrensschritte entsprechen dem ersten Ausführungsbeispiel.

In einem konventionell hergestellten selbstjustierten Heterobipolartransistor mit einem Emitter der Fläche von z. B. 5 x 2 µm² und mit zwei Basiskontakten gleicher Größe entfällt 2/3 der gesamten Basis-Kollektor-Kapazität auf die (parasitäre) extrinsische Basis-Kollektor-Kapazität. Durch die dem Stand der Technik entsprechende Isolationsimplantation mit Sauerstoff durch die fertige Schichtfolge des Transistors kann die extrinsische Basis-Kollektor-Kapazität nach den Angaben in der Literatur um etwa einen Faktor 2 verringert werden, d. h. es entfällt dann nur noch die Hälfte der Basis-Kollektor-Kapazität auf den Beitrag durch die extrinsische Basis-Kollektor-Kapazität. Als Folge davon verringern sich die Kollektorladezeit und die Emitterladezeit wesentlich. Das erfindungsgemäße Verfahren erlaubt nicht nur eine einfache Ausführung der Isolationsimplantation, sondern ermöglicht darüberhinaus eine praktisch vollständige Eliminierung der extrinsischen Basis-Kollektor-Kapazität, d. h. die Basis-Kollektor-Kapazität wird gegenüber herkömmlichen Transistoren auf ein Drittel reduziert. Die Vermeidung der parasitären extrinsischen Basis-Kollektor-Kapazität bietet weitere Vorteile: Die Anschlußgebiete für die Basiskontakte 7 können größer gewählt werden, wenn z. B. niedrigere Basiskontakt-Widerstände z. B. zur Erhöhung der maximalen Oszillationsfrequenz benötigt werden, da die extrinsische Basis-Kollektor-Kapazität nicht mehr berücksichtigt werden muß.

Das erfindungsgemäße Verfahren ist bei allen Materialsystemen anwendbar, bei denen auf ein semiisolierendes Substrat weitere Schichten, d. h. die Kollektorschicht (3), die Basisschicht (4) und die Emitterschicht (5), aufgewachsen werden. Solche Materialsysteme sind z. B. GaAs/GaAlAs, InP/InGaAs und Si/SiGe.

## Patentansprüche

1. Verfahren zur Herstellung eines auf einem Substrat (1) aus Halbleitermaterial angeordneten Bipolartransistors, bei dem übereinander eine Kollektorschicht (3), eine Basisschicht (4) und eine Emitterschicht (5) für die Ausbildung von Kollektor, Basis und Emitter aufgewachsen werden,
**dadurch gekennzeichnet,**
daß vor dem Aufwachsen der Kollektorschicht (3), der Basisschicht (4) und der Emitterschicht (5) ein Subkollektor (12) ausgebildet wird, der auf den für den Emitter und einen Kollektoranschluß vorgesehenen Bereich begrenzt ist.

2. Verfahren nach Anspruch 1,
**dadurch gekennzeichnet,**
daß eine Subkollektorschicht (2) auf das Substrat (1) aufgewachsen wird,
daß unter Verwendung einer ersten Maske (10), die den für den Subkollektor (12) vorgesehenen Bereich abdeckt, eine Isolationsimplantierung (15) vorgenommen wird und
daß nach dem Entfernen dieser ersten Maske (10) und nach dem Aufwachsen der Kollektcrschicht (3), der Basisschicht (4) und der Emitterschicht (5) der Emitter unter Verwendung einer zweiten Maske (13) auf den Subkollektor (12) justiert ausgebildet wird.

3. Verfahren nach Anspruch 1,
**dadurch gekennzeichnet,**
daß unter Verwendung einer ersten Maske (14), die den für den Subkollektor (12) vorgesehenen Bereich frei läßt, eine Dotierung in das Substrat (1) implantiert wird und
daß nach dem Entfernen dieser ersten Maske (14) und nach dem Aufwachsen der Kcllektorschicht (3), der Basisschicht (4) und der Emitterschicht (5) der Emitter unter Verwendung einer zweiten Maske (13) auf den Subkollektor (12) justiert ausgewird.

4. Verfahren nach einem der Ansprüche 1 bis 3,
**dadurch gekennzeichnet,**
daß das Substrat (1) semiisolierendes GaAs ist und
daß für die Kollektorschicht (3), die Basisschicht (4) und die Emitterschicht (5) Halbleitermaterialien aus dem System GaAs/GaAlAs aufgewachsen werden.

5. Verfahren nach einem der Ansprüche 1 bis 3,
**dadurch gekennzeichnet,**
daß das Substrat (1) semiisolierendes InP ist und
daß für die Kollektorschicht (3), die Basisschicht (4) und die Emitterschicht (5) Halbleitermaterialien aus dem System InP/InGaAs aufgewachsen werden.

6. Verfahren nach einem der Ansprüche 1 bis 3,
**dadurch gekennzeichnet,**
daß das Substrat (1) semiisolierendes Si ist und
daß für die Kollektorschicht (3), die Basisschicht (4) und die Emitterschicht (5) Halbleitermaterialien aus dem System Si/SiGe aufgewachsen werden.

7. Verfahren nach einem der Ansprüche 1 bis 6,
**dadurch gekennzeichnet,**
daß der Subkollektor (12), die Kollektorschicht (3) und die Emitterschicht (5) n-leitend dotiert werden.

## Claims

1. Method for the production of a bipolar transistor arranged on a substrate (1) of semiconductor material, in which a collector layer (3), a base layer (4) and an emitter layer (5) for forming the collector, base and emitter are grown one above the other, characterized in that, before the growth of the collector layer (3), of the base layer (4) and of the emitter layer (5), a sub-collector (12) is formed, which is limited to the region intended for the emitter and for a collector terminal.

2. Method according to Claim 1, characterized in that a sub-collector layer (2) is grown onto the substrate (1), in that, by using a first mask (10) which covers the region intended for the sub-collector (12), insulation implantation (15) is carried out and, after this first mask (10) has been removed and the collector layer (3), the base layer (4) and the emitter layer (5) have been grown, the emitter is formed, aligned on the sub-collector (12) by using a second mask (13).

3. Method according to Claim 1, characterized in that, by using a first mask (14) which exposes the region intended for the sub-collector (12), doping is implanted into the substrate (1), and in that, after this first mask (14) has been removed and after the collector layer (3), the base layer (4) and the emitter layer (5) have been grown, the emitter is formed, aligned on the sub-collector (12), by using a second mask (13).

4. Method according to one of Claims 1 to 3, characterized in that the substrate (1) is semi-insulating GaAs, and in that semiconductor materials of the system GaAs/GaA1As are grown for the collector layer (3), the base layer (4) and the emitter layer (5).

5. Method according to one of Claims 1 to 3, characterized in that the substrate (1) is semi-insulating InP, and in that semiconductor materials of the system InP/InGaAs are grown for the collector layer (3), the base layer (4) and the emitter layer (5).

6. Method according to one of Claims 1 to 3, characterized in that the substrate (1) is semi-insulating Si, and in that semiconductor materials of the system Si/SiGe are grown for the collector layer (3), the base layer (4) and the emitter layer (5).

7. Method according to one of Claims 1 to 6, characterized in that the sub-collector (12), the collector layer (3) and the emitter layer (5) are n-conductively doped.

## Revendications

1. Procédé de fabrication d'un transistor bipolaire porté par un substrat (1) en matériau semi-conducteur, dans lequel on dépose les unes au-dessus des autres une couche de collecteur (3), une couche de base (4) et une couche d'émetteur (5) pour la formation d'un collecteur, d'une base et d'un émetteur,
caractérisé
en ce qu'avant le dépôt de la couche de collecteur (3), de la couche de base (4) et de la couche d'émetteur (5), on forme un sous-collecteur (12) qui est limité à la région prévue pour l'émetteur et pour une connexion du collecteur.

2. Procédé selon la revendication 1,
caractérisé
en ce qu'on dépose une couche de sous-collecteur (2) sur le substrat (1),
en ce que, en utilisant un premier masque (10) qui recouvre la région prévue pour le sous-collecteur (12), on procède à une implantation d'isolant (15) et
en ce qu'après avoir enlevé ce premier masque (10) et après avoir déposé la couche de collecteur (3), la couche de base (4) et la couche d'émetteur (5), on forme l'émetteur de manière alignée sur le sous-collecteur (12) en utilisant un deuxième masque (13).

3. Procédé selon la revendication 1,
caractérisé
en ce qu'on implante un dopage dans le substrat (1) en utilisant un premier masque (14) qui laisse libre la région prévue pour le sous-collecteur (12), et
en ce qu'après avoir enlevé ce premier masque (14) et après avoir déposé la couche de collecteur (3), la couche de base (4) et la couche d'émetteur (5), on forme l'émetteur de manière alignée sur le sous-collecteur (12) en utilisant un deuxième masque (13).

4. Procédé selon l'une des revendications 1 à 3,
caractérisé
en ce que le substrat (1) est un GaAs semi-isolant et,
en ce que, pour la couche de collecteur (3), la couche de base (4) et la couche d'émetteur (5), on dépose des matériaux semi-conducteurs pris dans le système GaAs/GaAlAs.

5. Procédé selon l'une des revendications 1 à 3,
caractérisé
en ce que le substrat (1) est un InP semi-isolant et
en ce que, pour la couche de collecteur (3), la couche de base (4) et la couche d'émetteur (5), on dépose par épitaxie des matériaux semi-conducteurs pris dans le système InP/InGaAs.

6. Procédé selon l'une des revendications 1 à 3,
caractérisé
en ce que le substrat (1) est fait de Si semi-isolant et
en ce que, pour la couche de collecteur (3), la couche de base (4) et la couche d'émetteur (5), on dépose par épitaxie des matériaux semi-conducteurs pris dans le système Si/SiGe.

7. Procédé selon l'une des revendications 1 à 6,
caractérisé
en ce que le sous-collecteur (12), la couche de collecteur (3) et la couche d'émetteur (4) sont dopées pour posséder une conductivité N.
